# FASCICULE DE BREVET EUROPEEN

(11) **EP 2 599 746 B1**
(45) Date de publication et mention de la délivrance du brevet: **19.12.2018**
(21) Numéro de dépôt: 12194881.4
(22) Date de dépôt: 29.11.2012
(51) Int. Cl.: B81C 1/00

(54) **Procédé de réalisation d'une structure comportant au moins une partie active multi-épaisseur**
Verfahren zur Herstellung einer Struktur mit mindestens einem aus mehreren Dicken bestehenden aktiven Teil
Process for forming a structure having at least a multi-thickness active part

(30) Priorité: 30.11.2011 FR 1160972
(43) Date de publication de la demande: 05.06.2013
(73) Titulaire: Commissariat à l'Énergie Atomique et aux Énergies Alternatives, 75015 Paris (FR)
(72) Inventeur: Robert, Philippe, 38000 GRENOBLE (FR)
(74) Mandataire: Ilgart, Jean-Christophe

(56) Documents cités:
- DE-A1-102006 007 729
- US-A1- 2004 065 931
- US-A1- 2011 147 864
- PH. ROBERT ET AL: "M&NEMS: A new approach for ultra-low cost 3D inertial sensor", 2009 IEEE SENSORS, 1 octobre 2009 (2009-10-01), pages 963-966, XP055023740, DOI: 10.1109/ICSENS.2009.5398195 ISBN: 978-1-42-444548-6

## Description

### DOMAINE TECHNIQUE ET ART ANTÉRIEUR

La présente invention se rapporte à un procédé de réalisation d'une structure comportant au moins une partie active multiépaisseur pouvant être mise en oeuvre dans la réalisation de systèmes microélectromécaniques (MEMS ou "microelectromechanical systems" en terminologie anglo-saxonne) et/ou de systèmes nanoélectromécaniques (NEMS ou "nanoelectromechanical systems" en terminologie anglo-saxonne) pour la réalisation par exemple de capteurs ou d'actionneurs.

Les capteurs MEMS et NEMS comportent une partie fixe et au moins une partie suspendue par rapport à la partie fixe, la ou les parties suspendues appelées "parties actives" sont aptes à se déplacer et/ou se déformer sous l'effet d'une action extérieure, telle qu'une action mécanique, électrique, magnétique.

Le déplacement et/ou la déformation de la partie mobile par rapport à la partie fixe permet de déterminer par exemple une accélération dans le cas d'un accéléromètre, une force de Coriolis dans le cas d'un gyromètre. Le déplacement de la partie mobile est par exemple mesuré au moyen de jauge de contrainte.

Le document US 2011/147864 A1 décrit un procédé de réalisation d'une structure membranaire micro-mécanique comportant un accès par le côté arrière du substrat. Le procédé de réalisation de ce document utilise un substrat de départ à base de silicium dont une région, dans laquelle sera ultérieurement localisée la membrane, est rendue poreuse. L'article Ph. Robert, V. Nguyen, S. Hentz, L. Duraffourg, G. Jourdan, J. Arcamone, S. Harrisson, M&NEMS: A new approach for ultra-low cost 3D inertial sensor, IEEE SENSORS 2009 Conference - 25-28 October 2009 - Christchurch New Zealand, (2009*)* décrit une structure MEMS&NEMS formant un accéléromètre dans le plan. La structure comporte une partie active formée de deux épaisseurs actives distinctes : la partie NEMS formant une jauge de contrainte comporte une des épaisseurs actives, et la partie MEMS formant une masse sismique comporte les deux épaisseurs actives.

Le procédé de réalisation d'une telle partie active se fait à partir d'un substrat de type SOI ("Silicon on Insulator") qui a un coût de revient élevé. De plus, une étape de croissance épitaxiale épaisse est mise en oeuvre, une telle étape est généralement longue et coûteuse. La jauge de contrainte est formée à partir du substrat SOI et la masse sismique est formée à partir du substrat SOI et la couche formée par épitaxie épaisse.

Par ailleurs, l'étape de définition de la partie active met en oeuvre une couche d'oxyde sur laquelle la croissance épitaxiale aura en partie lieu.

Or, la couche formée par épitaxie sur la couche d'oxyde n'est pas monocristalline dans les zones d'interface entre les deux épaisseurs, qui étaient protégées par la couche d'oxyde. Ces zones « poly-cristallines » peuvent générer des défauts dans la structure.

De plus, la vitesse de croissance par épitaxie est différente entre les zones où la croissance se fait sur le silicium monocristallin et les zones où la croissance se fait sur la couche d'oxyde par exemple, qui forme l'interface des deux épaisseurs. Cette différence de vitesse de croissance peut conduire à des inhomogénéités d'épaisseur importante dans la structure finale.

Ce problème d'inhomogénéité de structure dû à la présence de zones polycristallines dans les couches monocristallines et d'inhomogénéité d'épaisseur est d'autant plus problématique dans le cas où l'on souhaite disposer de plus de deux couches distinctes ou de zones d'interface entre deux couches de grande surface.

### EXPOSÉ DE L'INVENTION

C'est par conséquent un but de la présente invention d'offrir un procédé de réalisation d'une structure comportant une partie active formée de plusieurs couches dont au moins une est en un matériau semi-conducteur monocristallin de coût réduit et plus rapide que les procédés utilisant un substrat SOI.

Le but de la présente invention est atteint par un procédé de réalisation d'une structure munie d'une partie active multicouche, comportant une étape de croissance par épitaxie d'un matériau semi-conducteur monocristallin sur un substrat dont au moins la face sur laquelle est effectuée l'épitaxie est en matériau semi-conducteur monocristallin, le substrat comportant au moins une zone dans laquelle le matériau semi-conducteur est discontinu.

On entend, dans la présente demande, par "zone dans laquelle le matériau semi-conducteur est discontinu ", une zone formée soit par un matériau poreux, soit par une pluralité de piliers en matériau semi-conducteur fins et disposés à faible distance les uns des autres.

L'étape d'épitaxie sert à former la première couche active similaire à celle formée à partir d'un substrat SOI. Cette première couche est généralement peu épaisse. La deuxième couche active, généralement plus épaisse que la première, est quant à elle formée avantageusement par toute ou partie de la partie « bulk » du premier substrat après scellement d'un second substrat, alors que dans le procédé connu utilisant un substrat SOI, cette deuxième couche active est formée par épitaxie. Les inconvénients liés à une épitaxie épaisse sont ainsi évités.

Grâce à l'invention, la couche épitaxiée, qui est monocristalline, croît sur une couche poreuse qui peut être retirée sélectivement par rapport à la couche épitaxiée, et par conséquent la couche poreuse joue le rôle de couche sacrificielle.

En outre, grâce à la croissance par épitaxie sur le matériau semi-conducteur discontinu, l'apparition de zones polycristallines aux interfaces n'apparaît pas et les vitesses de croissance sont sensiblement uniformes entre le matériau semi-conducteur discontinu et le matériau semi-conducteur monocristallin du substrat.

Puisque le procédé de réalisation selon l'invention ne nécessite pas l'emploi d'un substrat SOI et ne met pas en oeuvre d'épitaxie épaisse, il en résulte un gain en coût de fabrication et en temps. En outre, puisque les inhomogénéités d'épaisseur sont réduites, il n'est pas nécessaire d'avoir une étape de polissage mécano-chimique important pour rattraper les différences d'épaisseur.

De manière très avantageuse, dans le mode de réalisation d'une zone poreuse, celle-ci comporte des pores de très petite taille en surface, ce qui améliore la qualité du silicium qui croît par épitaxie sur cette zone poreuse, des pores de plus grande taille en profondeur, ce qui permet une gravure sélective ou une oxydation plus rapide.

La présente invention a alors pour objet un procédé de réalisation d'une structure comportant une partie active comportant au moins deux couches à partir d'un premier substrat comportant une première face en matériau semi-conducteur monocristallin, dite face avant, et une deuxième face opposée à la première face, dite face arrière, ledit procédé comportant les étapes suivantes ayant lieu dans cet ordre:
a) réalisation d'au moins une zone de matériau semi-conducteur discontinu, ladite zone étant formée par un matériau semi-conducteur poreux ou par une pluralité de piliers en matériaux semi-conducteurs fins disposés à faible distance les uns des autres, dans le premier substrat à partir de la face avant en matériau semi-conducteur monocristallin,
b) réalisation d'un dépôt par croissance épitaxiale d'une couche à partir d'un matériau semi-conducteur sur la face avant du premier substrat, ladite couche étant au moins monocristalline sur la surface de la zone de matériau semi-conducteur discontinu,
c) usinage de la couche monocristalline obtenue par épitaxie au moins au niveau de la zone de matériau semi-conducteur discontinu pour réaliser une première zone suspendue,
d) élimination ou oxydation du matériau semi-conducteur discontinu,
e) formation d'une couche sacrificielle attaquable sélectivement par rapport audit matériau semi-conducteur de la face avant et au matériau de la couche semi-conducteur épitaxiée de sorte à enrober entièrement ou partiellement la première zone suspendue, e') scellement ou dépôt d'un deuxième substrat en face avant du premier substrat,
f) usinage dans une première région de la face arrière du premier substrat, pour permettre d'atteindre la première zone suspendue et, dans une deuxième région de la face arrière du substrat, pour définir une deuxième zone suspendue, l'usinage étant tel que certaines des zones de la couche sacrificielle sont dégagées,
g) libération des première et deuxième zones suspendues par retrait d'une partie au moins de la couche sacrificielle.

Lors de l'étape e) la formation de la couche sacrificielle a lieu au moins sur la face avant et a pour effet d'enrober entièrement ou partiellement la première zone suspendue.

L'étape de croissance par épitaxie peut être réalisée dans le même matériau que le matériau semi-conducteur de la face avant du premier substrat ou dans un autre matériau semi-conducteur présentant de préférence un paramètre de maille voisin de celui du matériau de ladite face.

La formation de la couche sacrificielle est par exemple obtenue par dépôt d'un oxyde et/ou par oxydation thermique.

Dans un premier mode de réalisation, lors de l'étape a), est réalisée une zone en matériau semi-conducteur poreux. La zone matériau semi-conducteur poreux peut être obtenue par gravure électrochimique.

Dans un exemple avantageux, la zone en matériau semi-conducteur poreux comporte des pores de plus petite taille en surface et des pores de plus grande taille en profondeur.

Lors de l'étape d) l'élimination du matériau semi-conducteur poreux peut être réalisée par gravure, par exemple par gravure humide, ou par oxydation thermique du matériau semi-conducteur poreux et par gravure du matériau semi-conducteur poreux oxydé, par exemple par gravure humide et/ou vapeur.

Dans un autre mode de réalisation, lors de l'étape a), est réalisée une zone en matériau semi-conducteur comportant une pluralité de piliers de faible section et disposés à faible distance les uns des autres. L'étape a) peut comporter :
- une étape de formation d'un masque délimitant des piliers,
- une étape de gravure des zones inter-piliers,
- une étape de retrait du masque.

Dans ce mode de réalisation, l'élimination du matériau semi-conducteur formant les piliers lors de l'étape d) est obtenue par un recuit à une température voisine de la température de fusion dudit matériau.

De manière préférentielle, le procédé comporte, préalablement à l'étape e'), une étape de structuration du deuxième substrat. Par exemple, lors de l'étape de structuration, une face du deuxième substrat est gravée de sorte à réaliser des butées mécaniques pour la deuxième partie suspendue et un dépôt est effectué sur ladite face structurée d'une couche destiné à former une couche de scellement lors de l'étape de scellement du deuxième substrat.

Selon caractéristique additionnelle, le procédé peut comporter, suite à l'étape e), l'étape de structuration de la couche sacrificielle et/ou de dépôt d'une ou de plusieurs couches intermédiaires sur ladite couche sacrificielle, lesdites couches intermédiaires pouvant être structurées. Les structurations de la couche sacrificielle et de la ou des couches intermédiaires peuvent être réalisées, par exemple, par lithographie et gravure respectivement de la couche sacrificielle avec arrêt sur le substrat et de la ou des couches intermédiaires avec arrêt sur la couche sacrificielle.

Le procédé peut comporter une étape de dépôt d'une couche de SiO₂, de planarisation sur la couche sacrificielle structurée et/ou la ou les couches intermédiaires, ladite couche de SiO₂ participant au scellement.

Le scellement du premier et deuxième substrat peut être obtenu par scellement direct ou scellement eutectique.

Selon un exemple, le premier substrat est structuré avant l'étape a).

Après l'étape e'), le premier substrat et/ou le deuxième substrat peut ou peuvent être aminci(s) par abrasion en face arrière, puis polissage mécano-chimique.

Le procédé peut comporter préalablement à l'étape a) une étape de formation sur la face avant du substrat d'une couche en semi-conducteur poreux et de formations par épitaxie sur ladite couche en semi-conducteur poreux d'une couche en semi-conducteur monocristallin, ladite couche en semi-conducteur monocristallin formant la face avant à partir de laquelle la zone poreuse discontinue est formée. Suite au scellement, la couche en semi-conducteur poreux est par exemple gravée de sorte à amincir le premier substrat.

Dans le premier mode de réalisation, plusieurs zones en matériau semi-conducteur poreux peuvent être réalisées, celles-ci présentant de profondeurs différentes.

L'étape f) d'usinage pour réaliser une deuxième zone suspendue et d'usinage pour permettre la première zone suspendue peut être obtenue par usinage simultané du premier substrat au niveau desdites zones ou par usinage successif au niveau de chacune de ces zones.

Afin de réaliser une partie active ayant plus de deux couches, les étapes a) à e) sont répétées.

Le matériau semi-conducteur de la face avant du premier, substrat, le deuxième substrat et la couche réalisée par épitaxie sont de préférence en silicium.

Le procédé permet avantageusement de réaliser des structures microélectromécaniques et/ou nanoélectromécaniques pour réaliser des capteurs et/ou des actionneurs.

### BRÈVE DESCRIPTION DES DESSINS

La présente invention sera mieux comprise à l'aide de la description qui va suivre et des dessins en annexes sur lesquels :
- les figures 1A à 1H sont des représentations schématiques de différentes étapes d'un procédé de réalisation d'une structure à partie active selon un premier mode de réalisation ;
- les figures 2A à 2C sont des représentations schématiques de différentes étapes de réalisation d'une variante du procédé du premier mode de réalisation ;
- les figures 3A à 3E sont des représentations schématiques de différentes étapes de réalisation d'une autre variante du procédé du premier mode de réalisation ;
- les figures 4A à 4E sont des représentations schématiques de différentes étapes de réalisation d'une autre variante du procédé du premier mode de réalisation ;
- les figures 5A à 5D et 5A' sont des représentations schématiques des premières étapes d'un procédé de réalisation selon un deuxième mode de réalisation ;
- les figures 6A à 6E et 6A' sont des représentations schématiques des premières étapes d'une variante du procédé de réalisation selon un deuxième mode de réalisation.

### EXPOSÉ DÉTAILLÉ DE MODES DE RÉALISATION PARTICULIERS

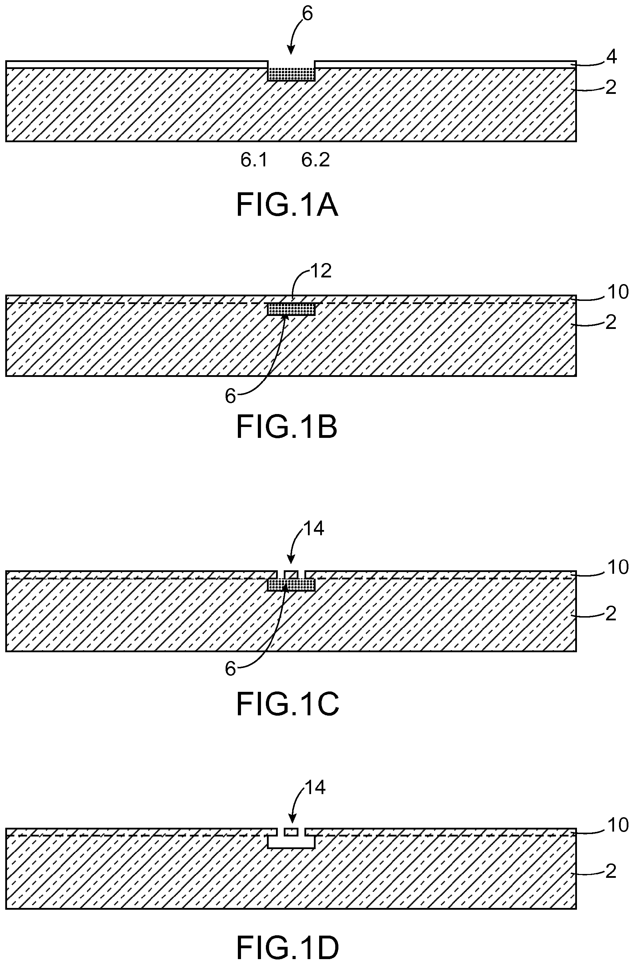

Sur les figures 1A à 1H, on peut voir les étapes d'un premier mode de réalisation d'un procédé de réalisation selon la présente invention d'une structure comportant une partie active formées de plusieurs couches, dont une au moins est en matériau semi-conducteur monocristallin.

Dans la présente demande, on désigne par " partie active " d'une structure MEMS et/ou NEMS une partie suspendue, susceptible de se déplacer et/ou se déformer sous l'effet d'une action extérieure (mécanique, électrique, magnétique,...).

Dans la description qui va suivre et à des fins de simplicité, l'exemple du silicium sera utilisé comme matériau semi-conducteur. Il est à noter que la mise en oeuvre de tout autre matériau semi-conducteur ne sort pas du cadre de la présente invention.

Le procédé selon le premier mode de réalisation comporte les étapes principales suivantes à partir d'un substrat silicium de type bulk :
a) la réalisation d'une ou plusieurs zones de silicium poreux sur tout ou partie de ce substrat,
b) la réalisation d'une épitaxie de silicium ou de SiGe monocristallin sur toute la surface du substrat et sur la surface de silicium poreux,
c) l'usinage de la couche de silicium ou de SiGe obtenue par épitaxie pour définir la forme de la première zone suspendue dans la première épaisseur de silicium monocristallin et ouvrir localement la portion de silicium poreux,
d) le retrait total ou partiel du silicium poreux, ou oxydation thermique du Si poreux,
e) le dépôt et/ou oxydation thermique d'une couche sacrificielle sélective par rapport au silicium,
f) l'usinage du premier substrat jusqu'à dégager sur certaines zones la couche sacrificielle et/ou tout ou partie des zones de silicium poreux pour réaliser une deuxième zone suspendue et dégager toute ou partie de la première zone suspendue,
g) la libération des zones suspendues par retrait de la couche sacrificielle.

Avantageusement, entre l'étape e) et f), on prévoit une étape e') de report ou dépôt d'un support en face arrière du premier substrat ainsi structuré.

Les étapes a) à g) du procédé vont maintenant être décrites en détail.

Le procédé selon l'invention utilise avantageusement un premier substrat 2 en silicium monocristallin.

Lors de la première étape a), on réalise un masque 4 sur la surface du substrat 2 par dépôt d'une couche mince d'environ 100 nm. Cette couche 4 est par exemple en nitrure de silicium.

Une étape de lithographie a ensuite lieu sur la couche 4 pour délimiter les zones de la couche 2 à graver et une étape de gravure de la couche 4 a lieu, découvrant une zone 6 du substrat 2.

Lors d'une étape suivante, la zone 6 est rendue poreuse sur une épaisseur donnée, par exemple par gravure électrochimique de porosification. Cette gravure est une gravure au temps. L'épaisseur de silicium rendu poreux est comprise entre 0,1 µm et 10 µm, avantageusement, elle est égale à environ 1 µm.

On obtient l'élément représenté schématiquement sur la figure 1A, la portion de silicium poreux est désignée par la référence 8.

La réalisation d'une ou plusieurs portions poreuses entre dans le cadre de la présente invention et dépend de la structure à réaliser.

De manière particulièrement avantageuse, la portion poreuse 6 comporte des pores 6.1 de très petite taille en surface, ce qui améliore la qualité du silicium qui croîtra par épitaxie sur cette portion poreuse, et des pores de plus grande taille 6.2 en profondeur, ce qui permet une gravure sélective ou une oxydation plus rapide du silicium poreux. Cette portion poreuse présentant différentes tailles de pores peut être obtenue en modifiant les conditions de gravure électrochimique pendant l'étape de porosification, par exemple en changeant la densité de courant. Par exemple, la taille des pores recherchée est comprise entre 2 et 50 nm, le matériau obtenu est alors du type mésoporeux.

Lors d'une étape suivante, le masque 4 est retiré, par exemple par gravure chimique du nitrure de silicium.

A lieu ensuite l'étape b) de croissance par épitaxie d'une couche 10 de silicium ou de SiGe, cette couche est monocristalline au-dessus de la portion poreuse 6 et peut être monocristalline ou polycristalline sur tout le reste de la surface du substrat. Le silicium ou le Si-Ge polycristallin peut être obtenu en déposant, par exemple une couche d'oxyde ou de nitrure à la surface du substrat avant épitaxie. L'épaisseur de la couche 10 est comprise entre quelques dizaines de nm et quelques dizaines de µm, avantageusement, elle est égale à environ à 0,25 µm.

La couche 10 peut être en matériau semi-conducteur identique à celui du premier substrat ou en un autre matériau semi-conducteur présentant de préférence un paramètre de maille voisin de celui du matériau du premier substrat. Par exemple, comme cela a été décrit ci-dessus, dans le cas d'un premier substrat en Si, on réalise par exemple une épitaxie de Si ou de SiGe.

A des fins de clarté, sur les représentations schématiques des différentes étapes, la couche 10 et le substrat 2 sont séparés par un trait en pointillés.

L'élément ainsi obtenu est représenté sur la figure 1B. La portion de silicium 12 formée au-dessus de la zone poreuse 6 sera gravée pour former une première zone suspendue 14.

Lors d'une étape suivante c), on définit la première zone suspendue 14. Pour cela, une lithographie a lieu pour réaliser un masque sur la surface de la couche 10 et ensuite une gravure de la portion 12 avec arrêt sur ou dans la portion de silicium poreux 6.

La gravure est par exemple une gravure profonde par ions réactifs ou DRIE ("deep reactive-ion etching" en anglais).

La première zone suspendue 14 forme dans le cas de structure dite M&NEMS la partie NEMS.

L'élément ainsi obtenu est représenté sur la figure 1C.

Lors d'une étape suivante d), on effectue le retrait de la portion poreuse 6 ou alors encore uniquement une oxydation de celle-ci.

Ce retrait peut être réalisé au moyen d'une gravure du silicium poreux par voie humide. Cette gravure a pour caractéristique de graver plus rapidement le silicium poreux que le silicium " non poreux ", ainsi en contrôlant le temps de gravure, le silicium poreux est retiré alors que la zone suspendue 14 n'a pas ou très peu été gravée. La durée de la gravure peut être comprise entre quelques secondes et quelques minutes, en fonction de la concentration et de la température de la solution de gravure utilisée, qui peut être du KOH, du TMAH (Hydroxyde de Tétraméthylammonium),....Typiquement, la gravure dure quelques minutes dans une solution de KOH à température ambiante.

De manière alternative, le retrait du silicium poreux est obtenu en deux étapes, tout d'abord en effectuant une oxydation thermique puis en gravant l'oxyde formé par une gravure à l'acide fluorhydrique vapeur et/ou humide. Le silicium poreux s'oxyde beaucoup plus rapidement que le silicium " non poreux ", ainsi en contrôlant la durée de l'étape d'oxydation, il est possible de n'oxyder quasiment que le silicium poreux. Par exemple, on cherche à oxyder une épaisseur de silicium de quelques dizaines de nm. Les conditions d'oxydation sont bien connues de l'homme du métier et ne seront pas décrites en détail. Selon cette alternative, cette gravure peut avoir lieu lors de la gravure de la couche sacrificielle qui sera décrite par la suite. La durée du procédé peut ainsi être avantageusement réduite.

L'élément ainsi obtenu est représenté sur la figure 1D.

Lors d'une étape suivante e), on réalise un dépôt 16 sur la face avant du premier substrat de sorte à enrober entièrement ou partiellement la première zone suspendue 14 et à recouvrir la face avant du premier substrat. Le matériau du dépôt 16 est sélectif par rapport au silicium il est par exemple en SiO₂. La couche 16 forme alors une couche sacrificielle. Cette couche 16 permet également de boucher (entièrement ou partiellement) les cavités résultantes de la gravure du
Si poreux. Avantageusement, on pourra procéder à une légère oxydation thermique du silicium, sur une profondeur de quelques 10 nm par exemple, avant le dépôt de cette couche 16. L'oxyde thermique autour de la zone suspendue 14 et dans la cavité, forme une couche d'arrêt et permet d'assurer une protection accrue lors de l'étape f) d'usinage. Dans le cas où le silicium poreux a été uniquement oxydé, l'enrobage est partiel ou ne fait que recouvrir la première zone suspendue 14.

Une étape de planarisation de la couche d'oxyde 16 peut avoir lieu dans le cas où la topologie ou la rugosité de la surface obtenue après dépôt de la couche 16 est trop importante. Cette planarisation est par exemple réalisée par polissage mécano-chimique.

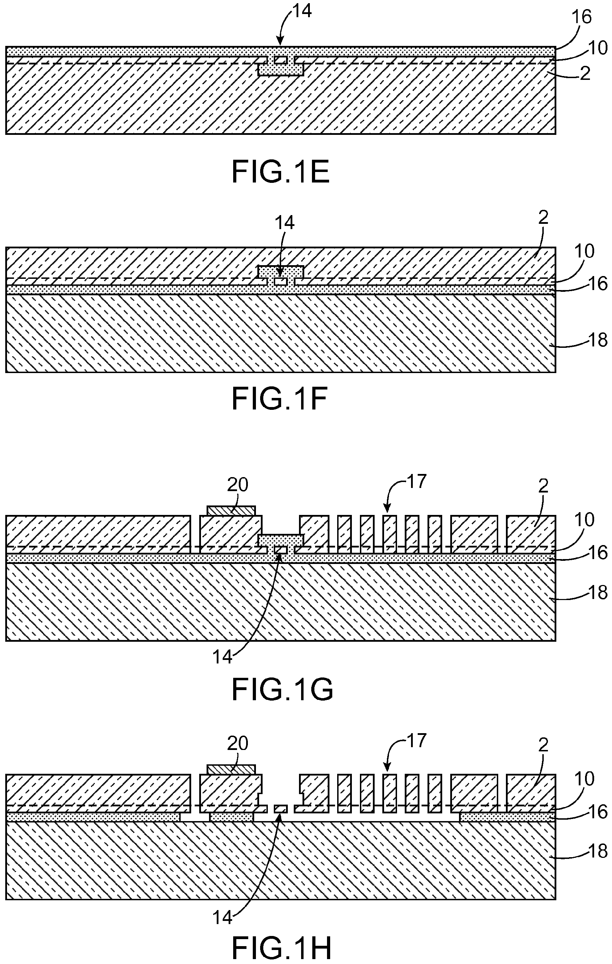

L'élément ainsi obtenu est représenté sur la figure 1E.

Avantageusement, un support est ensuite scellé ou déposé en face arrière du premier substrat (étape e'). Dans l'exemple représenté, le support est formé par un second substrat 18 en silicium monocristallin scellé sur le premier substrat en face avant. La couche sacrificielle 16 est alors disposée entre le premier substrat 2 et le second substrat 18.

L'assemblage est réalisé par exemple par scellement direct (ou SDB pour « Silicon Direct Bonding » en terminologie anglo-saxonne) qui est une technique bien connue par l'homme du métier. Dans le cas du dépôt du support ou deuxième substrat, celui-ci peut être réalisé par laminage.

Le support pourrait être en un matériau différent de celui du premier substrat, on peut même envisager d'utiliser un support en verre par exemple en Pyrex®.

L'élément ainsi obtenu est représenté sur la figure 1F.

Il peut être réalisé un amincissement du premier substrat, par exemple par abrasion en face arrière ou "back-grinding", puis polissage mécano-chimique.

Cette amincissement permet de définir l'épaisseur de la partie MEMS dans le cas de structures dites MEMS&NEMS.

Lors d'une étape suivante, on effectue un dépôt d'une couche métallique en vue de réaliser les contacts électrique 20, en face arrière du premier substrat 2, qui forme la face avant de l'élément obtenu par le scellement des premier et deuxième substrats.

Une étape de lithographie puis une étape de gravure sont réalisées pour former les contacts 20.

Lors d'une étape f), ont lieu une lithographie et une gravure, du type gravure profonde par ions réactifs ou DRIE ("deep reactive-ion etching" en anglais) par exemple, du premier substrat 2 de sorte à dégager la première zone suspendue 14 et à réaliser la deuxième zone suspendue 17, par exemple la partie MEMS dans le cas d'une structure dite MEMS&NEMS. La gravure atteint la couche sacrificielle 16 et le silicium poreux s'il n'a pas été retiré préalablement. Les étapes de structuration du premier substrat sont des étapes connues de la technologie MEMS&NEMS.

L'élément ainsi obtenu est représenté sur la figure 1G.

Enfin, lors d'une étape g), on libère les zones suspendues 14, 17 par exemple par une gravure humide ou en phase vapeur de la couche sacrificielle 16 et du silicium poreux oxydé, le cas échéant, à l'acide fluorhydrique. Il s'agit d'une gravure au temps (figure 1H).

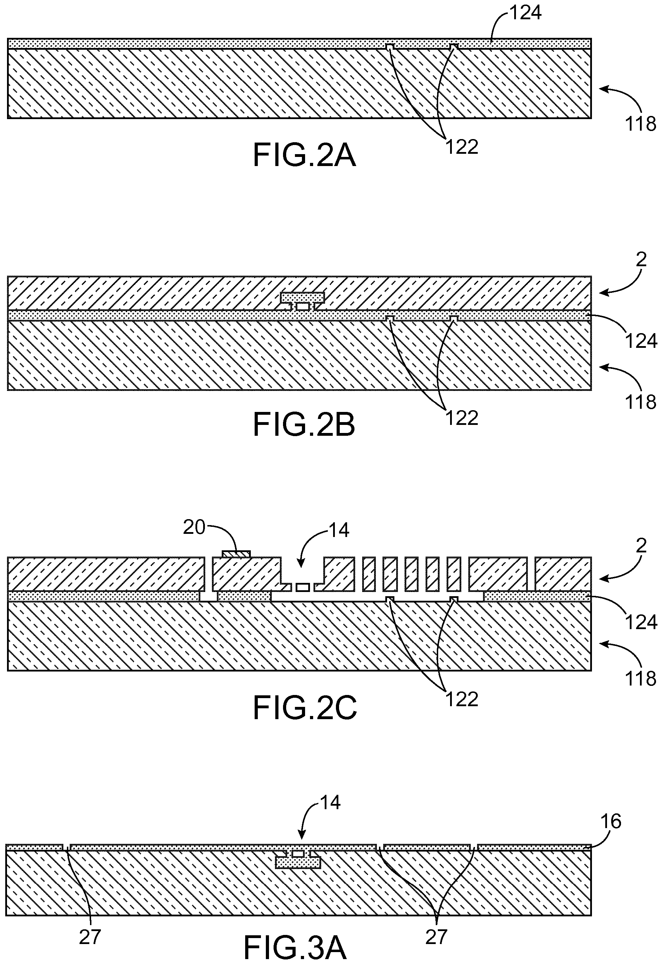

Sur les figures 2A à 2C, on peut voir une variante de réalisation du procédé de réalisation des figures 1A à 1H, dans lequel le second substrat 118 est structuré avant son scellement sur le premier substrat.

Une telle structuration préalable peut être réalisée pour la fabrication de circuits CMOS, afin de réaliser un substrat muni d'électrodes par exemple d'excitation de la ou des parties actives pour former un routage électrique, former une ou plusieurs cavités ...

La structuration du deuxième substrat 118 peut se faire de la manière suivante :
Lors d'une première étape, on réalise une étape de photolithographie pour délimiter les zones de la surface du substrat à graver et de gravure de la surface du substrat sur une profondeur par exemple de 0,5 µm. La gravure est une gravure avec arrêt avec le temps. On forme ainsi des butées mécaniques 122.

On dépose ensuite une couche de SiO₂ 124 sur la surface structurée, cette couche formera une couche de scellement.

Enfin une étape de planarisation de la couche 26 est effectuée.

L'élément ainsi obtenu est représenté sur la figure 2A.

Le scellement du deuxième substrat 118 structuré et du premier substrat 2 a ensuite lieu. La couche 24 est mise en contact avec la couche sacrificielle 16, par exemple par scellement direct comme décrit précédemment.

On effectue ensuite une étape d'amincissement du premier substrat par exemple par "back-grinding", ce qui permet par exemple de définir l'épaisseur de la partie MEMS dans le cas d'un système MEMS&NEMS.

L'élément ainsi obtenu est représenté sur la figure 2B.

On réalise ensuite les contacts électriques de manière similaire au procédé des figures 1A à 1H.

Ensuite, on structure le premier substrat 2 de manière similaire à l'étape f) et on libère les structures suspendues par de l'acide fluorhydrique. Lors de l'étape de libération, l'acide fluorhydrique grave la couche sacrificielle 16 et la couche 26.

L'élément ainsi obtenu est représenté sur la figure 2C. Dans l'exemple représenté, le deuxième substrat 118 comporte des butées mécaniques 22 vers le bas selon la direction verticale dans la représentation de la figure 2C réalisées préalablement au scellement avec le premier substrat.

Sur les figures 3A à 3E, on peut voir une autre variante d'un procédé de réalisation selon l'invention dans lequel la couche sacrificielle déposée sur le premier substrat est structurée avant scellement et des couches intermédiaires sont déposées sur la couche sacrificielle structurée, avant scellement.

Lors d'une première étape, ont lieu une étape de lithographie sur la couche sacrificielle 16 pour délimiter les zones 27 de la première couche 16 à graver et une étape de gravure de la couche 16 avec arrêt sur le silicium, i.e. sur la couche de silicium épitaxiée.

L'élément ainsi obtenu est représenté sur la figure 3A.

Lors d'une étape suivante, on effectue un dépôt d'une couche de polysilicium pour former, par exemple, une électrode inférieure 28.1 et un routage électrique 28.2.

Une étape de lithographie a ensuite lieu sur le couche 28 et une étape de gravure de la couche 28 a lieu avec arrêt sur la couche sacrificielle 16.

Lors d'une étape suivante, on effectue un dépôt d'une couche d'arrêt 30, par exemple en SiN qui est sélective par rapport au SiO₂ lors de l'étape de libération.

Ensuite, on dépose une couche de scellement 32 sur la couche 30, par exemple en SiO₂.

Enfin une étape de planarisation de la couche 32 a lieu, par exemple par polissage mécano-chimique.

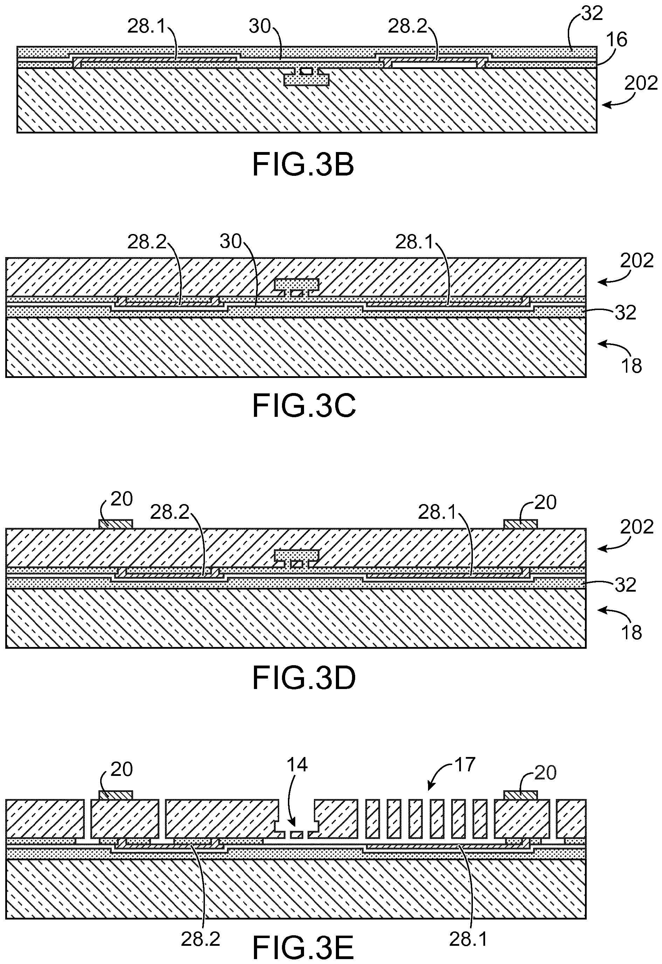

Le premier substrat 202 ainsi obtenu est représenté sur la figure 3B.

Lors d'une étape suivante, a lieu le scellement du premier substrat 202 et du deuxième substrat 18 ou 118. L'élément ainsi obtenu est représenté sur la figure 3C.

On effectue ensuite éventuellement une étape d'amincissement du premier substrat par exemple par "back-grinding", puis polissage mécano-chimique.

On réalise ensuite les contacts électriques 20 de manière similaire au procédé des figures 1A à 1H.

L'élément ainsi obtenu est représenté sur la figure 3D.

Ensuite, on structure le premier substrat 2 de manière similaire à l'étape g) et on libère les structures suspendues par gravure de la couche sacrificielle 16 par de l'acide fluorhydrique.

L'élément ainsi obtenu est représenté sur la figure 3E.

Grâce à la structuration de la couche sacrificielle 16 et au dépôt de couches intermédiaires, on peut réaliser une électrode inférieure formée par la portion 28.1 de polysilicium et un routage électrique formé par la portion de polysilicium 28.2 par exemple.

On peut prévoir alternativement soit de ne faire qu'une structuration de la couche sacrificielle, soit de déposer des couches intermédiaires sur une couche sacrificielle non structurée.

En variante, on peut prévoir d'usiner le premier substrat 2 avant la réalisation de la ou des portions de silicium poreux 6, par exemple pour réaliser un substrat muni d'électrode, un ou des routages électriques, une ou des cavités ...

Il a été décrit la possibilité d'amincir le premier substrat après scellement avec le deuxième substrat. Alternativement, on peut également amincir le premier et le deuxième substrat après scellement ou uniquement le deuxième substrat.

On peut envisager également de réaliser plusieurs portions de silicium poreux et plus généralement de matériau semi-conducteur poreux présentant des profondeurs différentes, ces profondeurs différentes étant obtenues par des étapes de porosification successives.

En outre, le procédé selon l'invention permet de réaliser plus de deux épaisseurs, en répétant les étapes a) à e), les couches sacrificielles intermédiaires, i.e. celles ne servant pas de couche d'interface lors du scellement, sont alors usinées suivant des motifs définis, avant épitaxie.

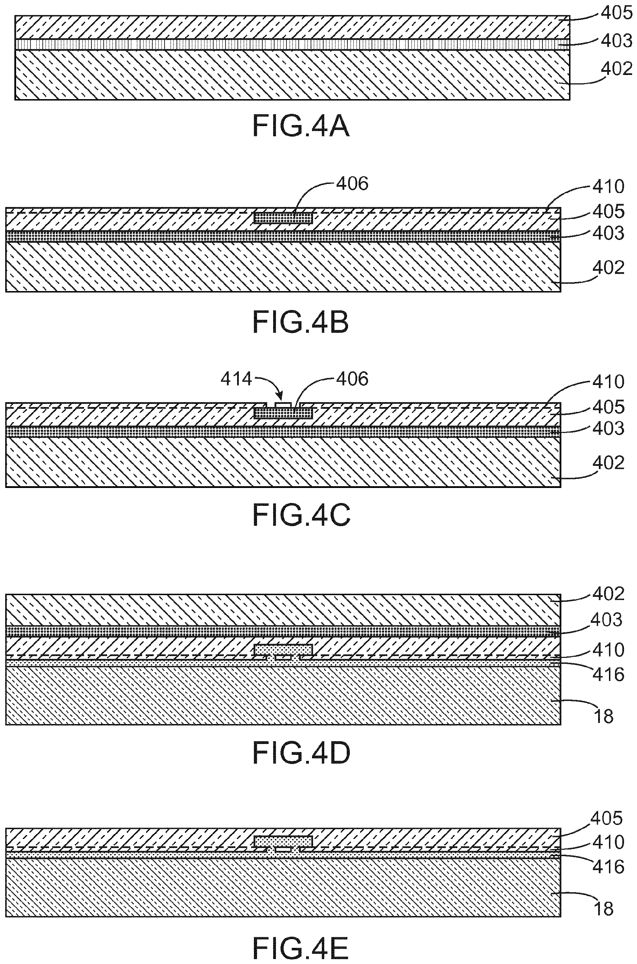

Nous allons décrire un exemple d'un tel procédé dont des étapes sont schématisées sur les figures 4A à 4E.

Lors d'une première étape, on réalise sur une face d'un substrat 402 en semi-conducteur monocristallin, par exemple en silicium, une couche 403 en silicium poreux qui s'étend sur toute la surface du substrat. La couche poreuse 403 est obtenue par exemple par gravure électrochimique de porosification. Cette gravure est une gravure au temps. L'épaisseur de silicium rendu poreux est comprise entre 0,5 µm et quelques dizaines de µm, avantageusement, elle est égale à environ 5µm.

On réalise ensuite une couche de silicium monocristallin 405 par croissance épitaxiale sur toute la couche poreuse 403. Cette couche a par exemple une épaisseur comprise entre 1 µm et quelques dizaines de µm. L'épaisseur de cette couche définit l'épaisseur de la partie MEMS dans une structure MEMS&NEMS.

L'élément ainsi obtenu est représenté sur la figure 4A.

Lors d'une étape suivante on réalise une zone 406 en silicium poreux de manière similaire à l'étape a) du procédé représenté sur les figures 1A à 1H, par lithographie par exemple au moyen d'un masque type SiN et porosification.

Ensuite, une couche de silicium d'un semi-conducteur 410 est formée par épitaxie, celle-ci étant monocristalline sur au moins la zone poreuse 406. La couche 410 a une épaisseur comprise par exemple entre quelques centaines de nm et quelques dizaines de µm.

L'épaisseur de cette couche définit par exemple l'épaisseur de la partie NEMS dans une structure MEMS&NEMS.

L'élément ainsi obtenu est représenté sur la figure 4B.

Lors d'une étape suivante, on effectue une lithographie pour délimiter une première structure suspendue 414 au-dessus de la zone poreuse 406, et on effectue ensuite une gravure, par exemple de type DRIE jusqu'à déboucher dans la zone poreuse 406. L'élément ainsi obtenu est représenté sur la figure 4C.

Ensuite on effectue un retrait du silicium poreux de la zone 406 de manière similaire au procédé décrit en relation avec les figures 1A à 1H, par exemple par gravure.

Lors d'une étape suivante, on réalise un dépôt 416 sur la face avant du premier substrat de sorte à enrober entièrement ou partiellement la première zone suspendue 114 et à recouvrir la face avant du premier substrat. Le matériau du dépôt 16 est sélectif par rapport au silicium il est par exemple en SiO₂. La couche 16 forme alors une couche sacrificielle.

Une étape de planarisation de la couche d'oxyde 16 peut avoir lieu dans le cas où la topologie ou la rugosité de la surface obtenue après dépôt de la couche 16 est trop importante. Cette planarisation est par exemple réalisée par polissage mécano-chimique.

Lors d'une étape suivante, un support est scellé ou déposé en face arrière du premier substrat.

Dans l'exemple représenté, le support est formé par un second substrat 118 en silicium monocristallin scellé sur le premier substrat en face avant. L'assemblage est réalisé par exemple par scellement direct (ou SDB pour « Silicon Direct Bonding » en terminologie anglo-saxonne) qui est une technique bien connue par l'homme du métier. Dans le cas du dépôt du support ou deuxième substrat, celui-ci peut être réalisé par laminage.

L'élément ainsi obtenu est représenté sur la figure 4D.

On effectue ensuite une gravure de la couche de silicium poreux 105, par exemple par gravure humide ; la partie du substrat située à l'opposé du premier élément suspendu par rapport à la couche poreuse 105 peut alors être retirée. On obtient de fait un amincissement du premier substrat.

Les étapes suivantes ne sont pas représentées, cependant celles-ci sont similaires aux étapes représentées sur les figures 1G et 1H.

Ce procédé offre l'avantage d'offrir un bon contrôle de l'épaisseur MEMS par épitaxie.

Les variantes du procédé de réalisation selon l'invention ne sont pas exclusives les unes des autres et peuvent être combinées.

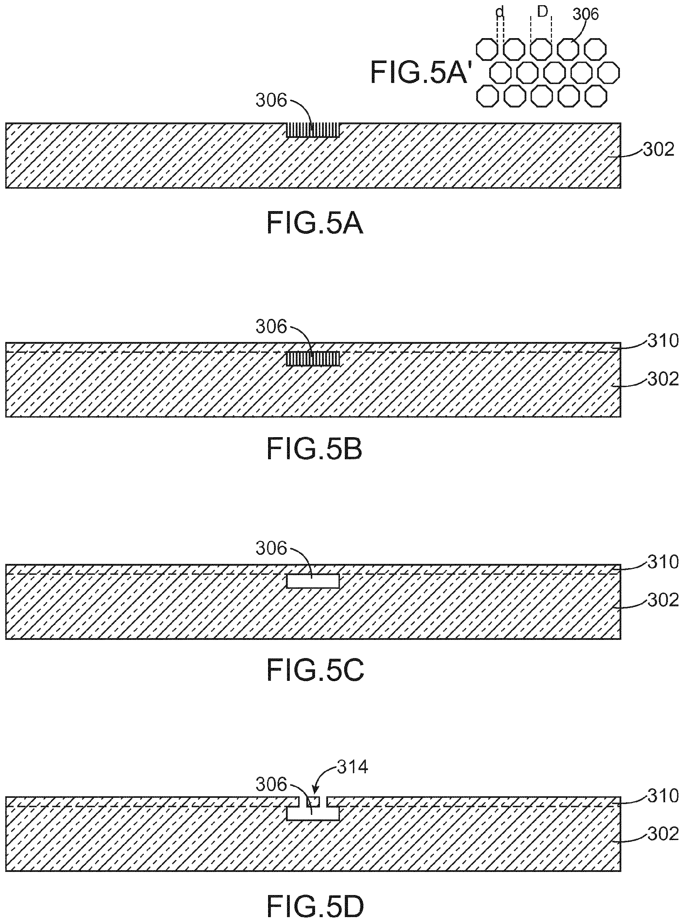

Sur les figures 5A à 5D, on peut voir représentées les premières étapes d'un deuxième mode de réalisation du procédé selon l'invention, qui diffère du premier mode de réalisation en ce qu'il n'est plus formé de zone dans laquelle le semi-conducteur est poreux mais une zone formée d'une pluralité de piliers fins et disposés à faible distance les uns des autres.

Les piliers présentent par exemple une largeur comprise entre environ 0,5 µm et 2 µm et sont disposés les uns des autres à une distance comprise entre environ 0,3 µm et 1 µm.

On utilise un premier substrat 302 en silicium monocristallin sur lequel sera réalisée la partie active.

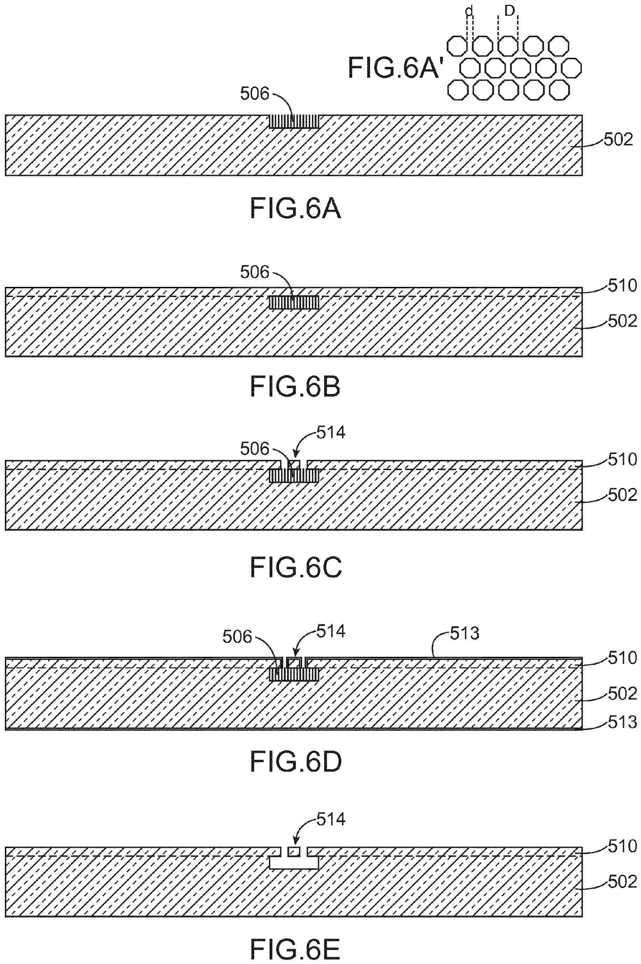

Lors d'une première étape, on réalise par photolithographie un masque sur la surface du substrat 302. Au niveau où la zone formée de piliers doit être réalisée, le masque définit par exemple un réseau en nid d'abeille tel que représenté vu de dessus sur la figure 6.

Ce masque délimite les zones inter-pilier à graver. La largeur des zones inter-pilier d est par exemple comprise entre 0,3 µm et 1 µm et la distance D entre deux faces parallèles d'un pilier est par exemple comprise entre 0,5 µm et 2 µm. La largeur d et la distance D sont représentées sur la figure 5A'.

Une étape de gravure du substrat 302 a ensuite lieu, par exemple de type DRIE avec arrêt au temps, sur une profondeur comprise typiquement entre 0,5 µm et 2 µm.

On obtient alors l'élément représenté schématiquement sur la figure 5A, la portion de silicium formée de piliers est désignée par la référence 306 (vue de détail).

Lors d'une étape suivante, le masque est retiré.

A lieu ensuite une étape de croissance par épitaxie d'une couche 310 de silicium monocristallin sur toute la surface du substrat 302 et sur le dessus des piliers de la portion 306. La couche ainsi formée a une épaisseur typiquement comprise entre 1 µm et quelques dizaines de µm. La couche épitaxiée 310 ferme la zone 306.

Par exemple, la croissance épitaxiale est réalisée dans un environnement désoxydant, par exemple sous atmosphère présentant une concentration en hydrogène élevée, de préférence utilisant du thrichlorosilane SiHCl₃. Une couche 310 épitaxiée croît sur la surface des piliers et ferme la cavité dans laquelle sont situés les piliers.

On obtient alors l'élément représenté schématiquement sur la figure 5B.

Après épitaxie, on effectue un recuit haute température à une température voisine de la température de fusion dudit matériau dans le cas de piliers en SiN, la température est d'environ 1200°C, ce qui fait collapser les piliers. Se forme alors une membrane suspendue 307 au-dessus de zone 306. Une planarisation par polissage mécano-chimique peut être réalisée pour améliorer l'état de surface et éventuellement amincir l'épaisseur de cette membrane.

L'élément ainsi obtenue est représenté sur la figure 5C.

Lors d'une étape suivante, on définit la première zone suspendue 314. Pour cela, une lithographie a lieu pour réaliser un masque sur la surface de la couche 310 et ensuite une gravure de la portion 312 avec arrêt dans la cavité.

La gravure est par exemple une gravure profonde par ions réactifs ou DRIE ("deep reactive-ion etching" en anglais).

La première zone suspendue forme dans le cas de structure dite M&NEMS la partie NEMS (figure 5D).

En variante et comme cela est représenté sur les figures 6A à 6E, on peut envisager une suppression partielle des piliers en procédant à une oxydation thermique de ces piliers. La figure 6A' représente une vue de dessus de l'élément de la figure 6A.

Les étapes représentées sur les figures 6A et 6B sont similaires à celles représentées sur les figures 5A et 5B et ne seront pas décrites.

Après la croissance par épitaxie, on effectue une lithographie et une gravure, par exemple par DRIE, de la couche épitaxiée 510 au-dessus des piliers, pour définir une première structure suspendue, par exemple la partie NEMS en technologie MEMS et NEMS jusqu'à déboucher dans la cavité renfermant les piliers. L'élément ainsi formé est représenté sur la figure 6C.

Lors d'une étape suivante, on réalise une étape de recuit haute température, qui est suffisante pour oxyder entièrement les piliers. Une couche d'oxyde 513 se forme également sur toute la surface de l'élément.

Il est à noter que lors de cette étape, la partie NEMS est également oxydée, ce qui provoque lors de l'étape de désoxydation une diminution de sa section. Cette diminution de section peut être anticipée en choisissant de manière adéquate la taille du masque de gravure du NEMS et l'épaisseur de la couche épitaxiée. L'élément ainsi formé est représenté sur la figure 6D.

Lors d'une étape suivante, l'oxyde est retiré par gravure humide ou vapeur par exemple au moyen d'acide fluorhydrique. Les piliers sont alors supprimés. L'élément ainsi formé est représenté sur la figure 6E.

Les étapes suivantes sont similaires à celles décrites dans le premier mode de réalisation et ne seront pas décrites ici.

Cette variante est particulièrement intéressante dans le cas où les piliers sont suffisamment fins, par exemple dans le cas où ils mesurent 0,6 µm de côté, et sont espacés de 0,3 µm.

Les variantes exposées en relation avec le procédé selon le premier mode de réalisation s'appliquent entièrement au procédé selon le deuxième mode de réalisation.

Grâce au procédé selon l'invention, il est possible de ne pas recourir à l'utilisation de substrat SOI et de ne plus effectuer d'épitaxie épaisse. Un gain en coût et en temps est alors obtenu. La durée du procédé est également réduite par le fait qu'il n'est plus nécessaire d'effectuer une étape de polissage mécano-chimique importante après épitaxie pour rattraper les différences d'épaisseur entre les zones monocristalline et polycristalline

Il est également possible de fonctionnaliser la couche sacrificielle, comme cela a été décrit précédemment pour former une ou des électrodes inférieures, un plan de masse relié à la couche MEMS, une ou des butées anti-collage, ...

Il est également possible grâce au procédé selon l'invention de réaliser plusieurs couches d'épaisseurs différentes en alternant plusieurs étapes de formation de semi-conducteur poreux et de croissance épitaxiale de semi-conducteur combinées éventuellement à des étapes intermédiaires de lithographie et de gravure.

Il est aussi possible de réaliser une co-intégration CMOS en trois dimensions. Dans ce cas, on remplace le deuxième substrat par un substrat CMOS.

La récupération des contacts peut se faire soit par des vias ou TSV (Through-silcon via en terminologie anglo-saxonne), soit lors du scellement, par un eutectique dans ce cas, type AIGe par exemple, qui sont des techniques bien connues de l'homme du métier.

Le procédé selon l'invention est particulièrement adapté à la réalisation de capteurs et d'actionneurs microélectromécaniques et/ou de systèmes nanoélectromécaniques.

## Revendications

1. Procédé de réalisation d'une structure comportant une partie active comportant au moins deux couches à partir d'un premier substrat comportant une première face en matériau semi-conducteur monocristallin, dite face avant, et une deuxième face opposée à la première face, dite face arrière, ledit procédé comportant les étapes suivantes ayant lieu dans cet ordre :
a) réalisation d'au moins une zone de matériau semi-conducteur discontinu, ladite zone étant formée par un matériau semi-conducteur poreux ou par une pluralité de piliers en matériaux semi-conducteurs fins disposés à faible distance les uns des autres, dans le premier substrat à partir de la face avant en matériau semi-conducteur monocristallin,
b) réalisation d'un dépôt par croissance épitaxiale d'une couche à partir d'un matériau semi-conducteur sur la face avant du premier substrat, ladite couche étant au moins monocristalline sur la surface de la zone de matériau semi-conducteur discontinu,
c) usinage de la couche monocristalline obtenue par épitaxie au moins au niveau de la zone de matériau semi-conducteur discontinu pour réaliser une première zone suspendue,
d) élimination ou oxydation du matériau semi-conducteur discontinu,
e) formation d'une couche sacrificielle attaquable sélectivement par rapport audit matériau semi-conducteur de la face avant et au matériau de la couche semi-conducteur épitaxiée de sorte à enrober entièrement ou partiellement la première zone suspendue,
e') scellement ou de dépôt d'un deuxième substrat en face avant du premier substrat,
f) usinage dans une première région de la face arrière du premier substrat, pour permettre d'atteindre la première zone suspendue et, dans une deuxième région de la face arrière du substrat, pour définir une deuxième zone suspendue, l'usinage étant tel que certaines des zones de la couche sacrificielle sont dégagées,
g) libération des première et deuxième zones suspendues par retrait d'une partie au moins de la couche sacrificielle.

2. Procédé selon la revendication 1, dans lequel l'étape de croissance par épitaxie est réalisée dans le même matériau que le matériau semi-conducteur de la face avant du premier substrat ou dans un autre matériau semi-conducteur présentant de préférence un paramètre de maille voisin de celui du matériau de ladite face.

3. Procédé selon la revendication 1 ou 2, dans lequel la formation de la couche sacrificielle est obtenue par dépôt d'un oxyde et/ou par oxydation thermique.

4. Procédé de réalisation selon l'une des revendications 1 à 3, dans lequel lors de l'étape a), est réalisée une zone en matériau semi-conducteur poreux, par exemple par gravure électrochimique.

5. Procédé de réalisation selon la revendication 4, dans lequel la zone en matériau semi-conducteur poreux comporte des pores de plus petite taille en surface et des pores de plus grande taille en profondeur.

6. Procédé de réalisation selon la revendication 4 ou 5, dans lequel lors de l'étape d) l'élimination du matériau semi-conducteur poreux est réalisée par gravure, par exemple par gravure humide ou par oxydation thermique du matériau semi-conducteur poreux et par gravure du matériau semi-conducteur poreux oxydé, par exemple par gravure humide et/ou vapeur.

7. Procédé de réalisation selon l'une des revendications 1 à 3, dans lequel lors de l'étape a), est réalisée une zone en matériau semi-conducteur comportant une pluralité de piliers de faible section et disposés à faible distance les uns des autres.

8. Procédé de réalisation selon la revendication 7, dans laquelle l'étape a) comporte :
- une étape de formation d'un masque délimitant des piliers,
- une étape de gravure des zones inter-piliers,
- une étape de retrait du masque.

9. Procédé de réalisation selon la revendication 7 ou 8, dans lequel lors de l'étape d) l'élimination du matériau semi-conducteur formant les piliers est obtenue par un recuit à une température voisine de la température de fusion dudit matériau.

10. Procédé de réalisation selon l'une des revendications 1 à 9, comportant, préalablement à l'étape e'), une étape de structuration du deuxième substrat.

11. Procédé de réalisation selon la revendication 10, dans lequel, lors de l'étape de structuration, une face du deuxième substrat est gravée de sorte à réaliser des butées mécaniques pour la deuxième partie suspendue et un dépôt est effectué sur ladite face structurée d'une couche destiné à former une couche de scellement lors de l'étape de scellement du deuxième substrat.

12. Procédé de réalisation selon l'une des revendications 1 à 11, comportant, suite à l'étape e), l'étape de structuration de la couche sacrificielle et/ou de dépôt de une ou plusieurs couches intermédiaires sur ladite couche sacrificielle, lesdites couches intermédiaires pouvant être structurées.

13. Procédé de réalisation selon la revendication 12, dans lequel les structurations de la couche sacrificielle et de la ou des couches intermédiaires sont réalisées par lithographie et gravure respectivement de la couche sacrificielle avec arrêt sur le substrat et de la ou des couches intermédiaires avec arrêt sur la couche sacrificielle.

14. Procédé de réalisation selon la revendication 12 ou 13, comportant une étape de dépôt d'une couche de SiO₂, de planarisation sur la couche sacrificielle structurée et/ou la ou les couches intermédiaires, ladite couche de SiO₂ participant au scellement.

15. Procédé de réalisation selon l'une des revendications 1 à 14, dans lequel le premier substrat est structuré avant l'étape a).

16. Procédé de réalisation selon l'une des revendications 1 à 15 en combinaison avec la revendication 4, dans lequel après l'étape e'), le premier substrat et/ou le deuxième substrat est/sont aminci(s) par abrasion en face arrière, puis polissage mécano-chimique.

17. Procédé de réalisation selon l'une des revendications 1 à 15, comportant préalablement à l'étape a) une étape de formation sur la face avant du substrat d'une couche en semi-conducteur poreux et de formations par épitaxie sur ladite couche en semi-conducteur poreux d'une couche en semi-conducteur monocristallin, ladite couche en semi-conducteur monocristallin formant la face avant à partir de laquelle la zone poreuse discontinue est formée.

18. Procédé de réalisation selon la revendication 17, dans lequel, suite au scellement, la couche en semi-conducteur poreux est gravée de sorte à amincir le premier substrat.

19. Procédé de réalisation selon l'une des revendications 4 à 6, dans lequel plusieurs zones en matériau semi-conducteur poreux sont réalisées, celles-ci présentant des profondeurs différentes.

20. Procédé de réalisation selon l'une des revendications 1 à 19, dans lequel l'étape f) d'usinage pour réaliser une deuxième zone suspendue et d'usinage pour permettre la première zone suspendue est obtenue par usinage simultané du premier substrat au niveau desdites zones ou par usinage successif au niveau de chacune de ces zones.

21. Procédé de réalisation selon l'une des revendications 1 à 20, dans lequel le matériau semi-conducteur de la face avant du premier substrat, le deuxième substrat et la couche réalisée par épitaxie sont en silicium.

22. Procédé de réalisation selon l'une des revendications 1 à 21, de structures microélectromécaniques et/ou nanoélectromécaniques pour réaliser des capteurs et/ou des actionneurs.

## Patentansprüche

1. Verfahren zur Herstellung einer Struktur, umfassend ein aktives Teil, das wenigstens zwei Schichten umfasst, ausgehend von einem ersten Substrat, das eine erste Fläche aus monokristallinem Halbleitermaterial umfasst, genannt Vorderfläche, und eine zweite zu der ersten Fläche entgegengesetzte Fläche, genannt Rückfläche, wobei das Verfahren die folgenden Schritte umfasst, die in dieser Reihenfolge ausgeführt werden:
a) Herstellen wenigstens einer Zone aus diskontinuierlichem Halbleitermaterial, wobei die Zone durch ein poröses Halbleitermaterial gebildet wird oder durch eine Mehrzahl von feinen Säulen aus Halbleitermaterialien, die in einem geringen Abstand zueinander angeordnet werden, und zwar in dem ersten Substrat ausgehend von der Vorderfläche aus monokristallinem Halbleitermaterial,
b) Herstellen einer Aufbringung durch epitaxiales Wachstum einer Schicht ausgehend von einem Halbleitermaterial auf der Vorderfläche des ersten Substrats, wobei die Schicht wenigstens monokristallin auf der Oberfläche der Zone aus diskontinuierlichem Halbleitermaterial ist,
c) Bearbeitung der durch Epitaxie erhaltenen monokristallinen Schicht wenigstens im Bereich der Zone aus diskontinuierlichem Halbleitermaterial, um eine erste aufgehängte Zone herzustellen,
d) Entfernen oder Oxidieren des diskontinuierlichen Halbleitermaterials,
e) Bilden einer Opferschicht, die bezüglich des Halbleitermaterials der Vorderfläche und des Materials der epitaxierten Halbleiterschicht selektiv angreifbar ist derart, dass die erste aufgehängte Zone vollständig oder teilweise umhüllt wird,
e') Versiegeln oder Aufbringen eines zweiten Substrats auf der Vorderfläche des ersten Substrats,
f) Bearbeitung in einer ersten Region der Rückfläche des ersten Substrats, um es zu ermöglichen, dass die erste aufgehängte Zone erreicht wird, und in einer zweiten Region der Rückfläche des Substrats, um eine zweite aufgehängte Zone zu definieren, wobei die Bearbeitung derart ist, dass bestimmte der Zonen der Opferschicht freigelegt werden,
g) Freilegen der ersten und der zweiten aufgehängten Zone durch Entfernen wenigstens eines Teils der Opferschicht.

2. Verfahren nach Anspruch 1, bei dem der Schritt des Wachstums mittels Epitaxie mit dem gleichen Material realisiert wird wie das Halbleitermaterial der Vorderfläche des ersten Substrats, oder mit einem anderen Halbleitermaterial, das vorzugsweise einen Gitterparameter nahe jenem des Materials der Fläche aufweist.

3. Verfahren nach Anspruch 1 oder 2, bei dem die Bildung der Opferschicht durch Aufbringen eines Oxyds und/oder durch thermische Oxidation erhalten wird.

4. Verfahren zur Herstellung nach einem der Ansprüche 1 bis 3, bei dem während des Schritts a) eine Zone aus porösem Halbleitermaterial hergestellt wird, beispielsweise durch elektrochemisches Ätzen.

5. Verfahren zur Herstellung nach Anspruch 4, bei dem die Zone aus porösem Halbleitermaterial Poren mit kleinerer Größe an der Oberfläche und Poren mit größerer Größe in der Tiefe umfasst.

6. Verfahren zur Herstellung nach Anspruch 4 oder 5, bei dem während des Schritts d) das Entfernen des porösen Halbleitermaterials durch Ätzen realisiert wird, beispielsweise durch Nassätzen oder durch thermische Oxidation des porösen Halbleitermaterials und durch Ätzen des oxidierten porösen Halbleitermaterials, beispielsweise durch Nass- und/oder Dampfätzen.

7. Verfahren zur Herstellung nach einem der Ansprüche 1 bis 3, bei dem während des Schritts a) eine Zone aus Halbleitermaterial hergestellt wird, die eine Mehrzahl von Säulen mit geringem Querschnitt umfasst, die in kleinem Abstand voneinander angeordnet sind.

8. Verfahren zur Herstellung nach Anspruch 7, bei dem der Schritt a) umfasst:
- einen Schritt des Bildens einer Maske, die Säulen begrenzt,
- einen Schritt des Ätzens der Zwischensäulenzonen,
- einen Schritt des Entfernens der Maske.

9. Verfahren zur Herstellung nach Anspruch 7 oder 8, bei dem während des Schritts d) das Entfernen des Halbleitermaterials, das die Säulen bildet, durch ein Tempern bei einer Temperatur nahe der Schmelztemperatur des Materials erhalten wird.

10. Verfahren zur Herstellung nach einem der Ansprüche 1 bis 9, umfassend vor dem Schritt e') einen Schritt der Strukturierung des zweiten Substrats.

11. Verfahren zur Herstellung nach Anspruch 10, bei dem während des Schritts der Strukturierung eine Fläche des zweiten Substrats derart geätzt wird, dass mechanische Anschläge für den zweiten aufgehängten Teil realisiert werden, und eine Aufbringung, auf der strukturierten Fläche einer Schicht durchgeführt wird, die dazu ausgelegt ist, eine Versiegelungsschicht während des Schritts der Versiegelung des zweiten Substrats zu bilden.

12. Verfahren zur Herstellung nach einem der Ansprüche 1 bis 11, umfassend im Anschluss an den Schritt e) den Schritt der Strukturierung der Opferschicht und/oder der Aufbringung von einer oder mehreren Zwischenschichten auf der Opferschicht, wobei die Zwischenschichten strukturiert sein können.

13. Verfahren zur Herstellung nach Anspruch 12, bei dem die Strukturierungen der Opferschicht und der Zwischenschicht(en) realisiert werden durch Lithographie und Ätzen der Opferschicht mit Halt auf dem Substrat beziehungsweise der Zwischenschicht(en) mit Halt auf der Opferschicht.

14. Verfahren zur Herstellung nach Anspruch 12 oder 13, umfassend einen Schritt des Aufbringens einer Schicht aus SiO₂, der Planarisierung auf der strukturierten Opferschicht und/oder der oder den Zwischenschicht(en), wobei die Schicht aus SiO₂ zu der Versiegelung beiträgt.

15. Verfahren zur Herstellung nach einem der Ansprüche 1 bis 14, bei dem das erste Substrat vor dem Schritt a) strukturiert wird.

16. Verfahren zur Herstellung nach einem der Ansprüche 1 bis 15 in Kombination mit Anspruch 4, bei dem nach dem Schritt e') das erste Substrat und/oder das zweite Substrat durch Abrasion an der Rückfläche und anschließendes mechanisch-chemisches Polieren abgedünnt wird/werden.

17. Verfahren zur Herstellung nach einem der Ansprüche 1 bis 15, umfassend vor dem Schritt a) einen Schritt des Bildens, auf der Vorderfläche des Substrats, einer Schicht aus porösem Halbleiter, sowie des Bildens, durch Epitaxie auf der Schicht aus porösem Halbleiter, einer Schicht aus monokristallinem Halbleiter, wobei die Schicht aus monokristallinem Halbleiter die Vorderfläche bildet, ausgehend von der die diskontinuierliche poröse Zone gebildet wird.

18. Verfahren zur Herstellung nach Anspruch 17, bei dem im Anschluss an die Versiegelung die Schicht aus porösem Halbleiter derart geätzt wird, dass das erste Substrat abgedünnt wird.

19. Verfahren zur Herstellung nach einem der Ansprüche 4 bis 6, bei dem mehrere Zonen aus porösem Halbleitermaterial hergestellt werden, wobei diese verschiedene Tiefen aufweisen.

20. Verfahren zur Herstellung nach einem der Ansprüche 1 bis 19, bei dem der Schritt f) der Bearbeitung zur Herstellung einer zweiten aufgehängten Zone und der Bearbeitung zum Erzielen der ersten aufgehängten Zone durch gleichzeitige Bearbeitung des ersten Substrats in Bereich dieser Zonen erhalten wird, oder durch sukzessive Bearbeitung im Bereich jeder dieser Zonen.

21. Verfahren zur Herstellung nach einem der Ansprüche 1 bis 20, bei dem das Halbleitermaterial der Vorderfläche des ersten Substrats, das zweite Substrat und die durch Epitaxie hergestellte Schicht aus Silizium sind.

22. Verfahren zur Herstellung nach einem der Ansprüche 1 bis 21 von mikroelektromechanischen und/oder nanoelektromechanischen Strukturen zur Herstellung von Sensoren und/oder Betätigungselementen.

## Claims

1. A method for manufacturing a structure comprising an active part comprising at least two layers from a first substrate comprising a first face of single crystal semi-conductor material, called the front face, and a second face opposite the first face, called the back face, said method comprising the steps of, which take place in the following order:
a) making at least one zone of discontinuous semi-conductor material, said zone being formed either by a porous material, or a plurality of thin pillars of semi-conductor material and provided a short distance apart from each other, in the first substrate from the front face of single crystal semi-conductor material,
b) making an epitaxial growth deposition of a layer from a semi-conductor material onto the front face of the first substrate, said layer being at least a single crystal one on the surface of the zone of discontinuous semi-conductor material,
c) machining the epitaxially grown single crystal layer at least at the zone of discontinuous semi-conductor material to make a first suspended zone,
d) removing or oxidizing the discontinuous semi-conductor material,
e) forming a sacrificial layer being selectively etchable with respect to said semi-conductor material of the front face and to the material of the epitaxially grown semi-conductor layer so as to completely or partly coat the first suspended zone,
e') bonding or depositing a second substrate onto the front face of the first substrate,
f) machining in a first area of the back face of the first substrate to reach the first suspended zone and, in as second area of the back face of the substrate to define a second suspended zone, the machining being such that some area of the sacrificial layer are cleared up,
g) releasing the first and second suspended zones by withdrawing at least one part of the sacrificial layer.

2. The method according to claim 1, wherein the epitaxial growth step is made in the same material as the semi-conductor material of the front face of the first substrate or in another semi-conductor material preferably having a lattice parameter close to that of the material of said face.

3. The method according to claim 1 or 2, wherein forming the sacrificial layer is achieved by depositing an oxide and/or by thermal oxidation.

4. The manufacturing method according to one of claims 1 to 3, wherein during step a), a zone of porous semi-conductor material is made, for example by electrochemical etching.

5. The manufacturing method according to claim 4, wherein the zone of porous semi-conductor material comprises smaller size pores on the surface and greater size pores in depth.

6. The manufacturing method according to claim 4 or 5, wherein during step d), removing the porous semi-conductor material is made by etching, for example by wet etching or by thermally oxidizing the porous semi-conductor material and by etching the oxidized porous semi-conductor material, for example by wet etching and/or vapour.

7. The manufacturing method according to one of claims 1 to 3, wherein during step a), a zone of semi-conductor material is made comprising a plurality of small cross-sectional area pillars and provided a short distance apart from each other.

8. The manufacturing method according to claim 7, wherein step a) comprises:
- a step of forming a mask bounding pillars,
- a step of etching interpillar zones,
- a step of withdrawing the mask.

9. The manufacturing method according to claim 7 or 8, wherein during step d), removing the semi-conductor material forming pillars is achieved by annealing at a temperature close to the melting temperature of said material.

10. The manufacturing method according to one of claims 1 to 9, comprising, prior to step e'), a step of structuring the second substrate and after step e) and before step f), a step e') of bonding or depositing a second substrate onto the front face of the first substrate.

11. The manufacturing method according to claim 10, wherein, during the structuring step, a face of the second substrate is etched so as to make mechanical stops for the second suspended part and a deposition is performed on said structured face of a layer intended to form a bonding layer during the bonding step of the second substrate.

12. The manufacturing method according to one of claims 1 to 11, comprising, following step e), the step of structuring the sacrificial layer and/or depositing one or more intermediate layers on said sacrificial layer, wherein said intermediate layers can be structured.

13. The manufacturing method according to claim 12, wherein the structurations of the sacrificial layer and of the one or more intermediate layers are performed through lithography and etching respectively of the sacrificial layer with stop on the substrate and the one or more intermediate layers with stop on the sacrificial layer.

14. The manufacturing method according to claim 12 or 13 comprising a step of depositing a SiO₂ layer, planarizing on the structured sacrificial layer and/or the one or more intermediate layers, said SiO₂ layer taking part in the bonding.

15. The manufacturing method according to one of claims 1 to 14, wherein the first substrate is structured before step a).

16. The manufacturing method according to one of claims 1 to 15 in combination with claim 4, wherein after step e'), the first substrate and/or the second substrate is/are thinned down by back-grinding the back face, and then chemical-mechanical polishing.

17. The manufacturing method according to one of claims 1 to 15, comprising prior to step a), a step of forming on the front face of the substrate a porous semi-conductor layer and epitaxially growing on said porous semi-conductor layer a single crystal semi-conductor layer, said single crystal semi-conductor layer forming the front face from which the discontinuous porous zone is formed.

18. The manufacturing method according to claim 17, wherein, following the bonding, the porous semi-conductor layer is etched so as to thin down the first substrate

19. The manufacturing method according to one of claims 4 to 6, wherein several zones of porous semi-conductor material are made, the latter having different depths.

20. The manufacturing method according to one of claims 1 to 19, wherein step f) of machining for making a second suspended zone and machining to afford the first suspended zone is achieved by simultaneously machining the first substrate at said zones or by successively machining at each of these zones.

21. The manufacturing method according to one of claims 1 to 20, wherein the semi-conductor material of the front face of the first substrate, the second substrate and the epitaxially grown layer are of silicon.

22. The method according to one of claims 1 to 21, for making microelectromechanical and/or nanoelectromechanical structures for making sensors and/or actuators.
